(19) Europäisches Patentamt
European Patent Office
Office européen des brevets

(11) Veröffentlichungsnummer: **0 373 438**
**A2**

(12) **EUROPÄISCHE PATENTANMELDUNG**

(21) Anmeldenummer: **89122177.2**

(51) Int. Cl.5: **G03F 7/11**

(22) Anmeldetag: **01.12.89**

(30) Priorität: **14.12.88 DE 3842028**

(43) Veröffentlichungstag der Anmeldung:
**20.06.90 Patentblatt 90/25**

(84) Benannte Vertragsstaaten:
**BE CH DE FR GB IT LI NL**

(71) Anmelder: **BASF Aktiengesellschaft**
**Carl-Bosch-Strasse 38**
**D-6700 Ludwigshafen(DE)**

(72) Erfinder: **Seitz, Friedrich, Dr.**
**Von-Wieser-Strasse 1**
**D-6701 Friedelsheim(DE)**
Erfinder: **Huemmer, Wolfgang**
**Vischerstrasse 16**
**D-6703 Limburgerhof(DE)**
Erfinder: **Zuerger, Manfred**
**Holderlandstrasse 2**
**D-6920 Sinsheim(DE)**

(54) **Photoresistfilm mit löslicher Zwischenschicht.**

(57) Die Erfindung betrifft Photoresistfilme mit löslicher Zwischenschicht.
Diese bestehen im wesentlichen aus
(i) einer Trägerfolie,
(ii) einer darauf aufgebrachten Zwischenschicht und
(iii) einer auf der Zwischenschicht aufgebrachten photoempfindlichen Schicht und gegebenenfalls
(iv) einer Deckfolie wobei die Zwischenschicht (ii) aus einem modifizierten Vinylalkoholpolymer besteht.
Die erfindungsgemäßen Photoresistfilme eignen sich insbesondere für die Herstellung gedruckter Schaltungen.

EP 0 373 438 A2

## Photoresistfilm mit löslicher Zwischenschicht

Die Erfindung betrifft einen Photoresistfilm, der mindestens aus einem dimensionsstabilen Träger, einer darauf aufgebrachten Zwischenschicht und einer auf der Zwischenschicht aufgebrachten photoempfindlichen Schicht sowie gegebenenfalls einer darauf aufgebrachten Deckfolie besteht, wobei die Zwischenschicht aus einem in Wasser oder wäßriger Lösung löslichen oder dispergierbaren modifizierten Vinylalkohol-Polymeren bestimmter Zusammensetzung besteht.

Photoresistfilme bestehen üblicherweise aus einer Trägerfolie, einer darauf aufgebrachten photoempfindlichen Schicht und einer Deckfolie. In den meisten Fällen besteht die Trägerfolie aus Polyethylenterephthalat, die Deckfolie aus Polyethylen. Bei der Herstellung von Leiterplatten ist es erforderlich, die Trägerfolie im Verlauf der Verarbeitung abzuziehen. Beispielsweise kann nach US-A-3 469 982 eine gedruckte Schaltung dadurch hergestellt werden, daß zunächst eine auf einer Trägerfolie aufgebrachte photopolymerisierbare Schicht auf eine geeignete Oberfläche aufgebracht wird, die photopolymerisierbare Schicht durch die Trägerfolie hindurch bildmäßig belichtet wird, die Trägerfolie dann abgezogen wird und die nicht belichteten Teile der photopolymerisierbaren Schicht durch eine geeignete Entwicklerlösung entfernt werden. Das Abziehen der Trägerfolie erfolgt an den vereinzelten Platten und ist daher nur schwer zu automatisieren. Es wird daher meist von Hand durchgeführt, was mit hohen Personalkosten verbunden ist. Es sind auch mechanische Vorrichtungen im Handel, die die Trägerfolie mit Hilfe eines Klebebandes oder eines mechanischen Greifers ergreifen und auf diese Weise das Abziehen der Trägerfolie besorgen sollen. Jedoch erfordern die genannten Vorrichtungen zusätzliche Investitionen und sind zudem störanfällig.

Sehr viel leichter läßt sich das Abziehen der Trägerfolie automatisieren, wenn das Abziehen vor der Vereinzelung der Platten erfolgt, weil die Trägerfolie dann an einem Stück auf eine Rolle gewickelt werden kann. Die hierfür erforderlichen technischen Einrichtungen sind bekannt und bewährt. Beispielsweise kann das Abziehen der Deckfolie von Photoresistfilmen vor dem Laminieren auf diese Weise vorgenommen werden. Eine unerwünschte Folge dieses Verfahrens ist es allerdings, daR bei der üblichen Kontaktbelichtung die verwendete bildmäßige Vorlage mit der photoempindlichen Schicht in Berührung kommt. Wegen der für eine ausreichende Haftung zur Kupferoberfläche des Leiterplattensubstrats notwendigen und stets, wenn auch oft nur in geringem Umfang, vorhandenen Klebrigkeit des unbelichteten Resistfilms führt dies zu einer raschen Verschmutzung der Vorlagen.

Die genannten Probleme sollten sich ohne Beeinträchtigung der übrigen Eigenschaften des photopolymerisierbaren Aufzeichnungsmaterials vermeiden lassen, wenn zwischen der dimensionsstabilen Trägerfolie und der photoempfindlichen Schicht eine lösliche Zwischenschicht aufgebracht wird. Da diese Zwischenschicht keinen Beitrag zur mechanischen Stabilität des Verbundes aus Trägerfolie, Zwischenschicht und photoempfindlicher Schicht leisten muß, kann ihre Dicke auf wenige µm beschränkt werden. Als zusätzlicher Vorteil kommen dann, wegen des geringeren Abstands zwischen Vorlage und photoempfindlicher Schicht, die verbesserten Abbildungseigenschaften, insbesondere die höhere optische Auflösung eines Photoresistfilms mit Zwischenschicht hinzu.

In US-A-4 530 896 ist ein solcher verbesserter Photoresistfilm beschrieben. Als Materialien für die Zwischenschicht werden hier z.B. vorgeschlagen: Salze von Polyvinylether-Maleinsäureanhydrid-Copolymeren, wasserlösliche Celluloseether, Salze von Carboxylalkylcellulose, Salze von Carboxyalkylstärke, Polyvinylalkohol, Polyvinylpyrrolidon, Polyacrylamide, wasserlösliche Polyamide, Salze der Polyacrylsäure, Gelatine oder Polyethylenoxidpolymere. Wegen der leichten Verfügbarkeit hat von diesen Verbindungen Polyvinylalkohol die meiste Beachtung gefunden, jedoch treten auch hier einige gravierende Probleme auf, die einer breiteren Anwendung hinderlich sind. Ein Problem ist die Bildung von Gelen, wenn Polyvinylalkohol in Lösungen mit hoher Ionenstärke eingebracht wird, wie sie Entwicklerlösungen für wäßrig entwickelbare Photoresiste typischerweise darstellen. Diese Gelteilchen haften an der Metalloberfläche und führen zu Abbildungsfehlern. Ein weiteres Problem bei der Verwendung von Polyvinylalkohol besteht in der zu geringen Haftung zu den als Trägerfolie üblicherweise verwendeten Polyesterfolien, die häufig zu einer unerwünschten vorzeitigen Ablösung der Trägerfolie führt.

Zur Umgehung dieser Schwierigkeiten wird in EP-A-267 807 die Verwendung von carboxyliertem Polyvinylalkohol vorgeschlagen. Gemäß EP-A-267 807 tritt bei Verwendung von carboxyliertem Polyvinylalkohol in den üblichen basischen Entwicklermedien keine Gelbildung auf, im Gegensatz zu gewöhnlichem Polyvinylalkohol. Auch soll die Einführung der Carboxylgruppen die Haftung zu Polyesterfolien erheblich verbessern. Bei erhöhten Temperaturen, wie sie unmittelbar nach dem Laminieren auftreten, ist die Haftung zwischen der Zwischenschicht aus carboxyliertem Polyvinylalkohol und der Polyesterträgerfolie jedoch zu hoch. Die Leiterplattensubstrate müssen daher nach dem Laminieren abgekühlt werden, bevor die Trägerfolie entfernt werden kann. In EP-A-267 807 wird daher als bevorzugte Ausführungsform angegeben, als

Zwischenschicht Mischungen aus carboxyliertem Polyvinylalkohol und Hydroxyethylcellulose zu verwenden, wobei letztere in einem Anteil bis zu 90 Gew.% vorliegt. Solche Mischungen sollen, insbesondere bei höheren Temperaturen, eine bessere Haftungsdifferenzierung der Zwischenschicht zu Polyesterträgerfolie bzw. photoempfindlicher Schicht aufweisen.

Zwei verschiedene Polymere sind jedoch, von wenigen Ausnahmen abgesehen, thermodynamisch nicht mischbar. Bei der Verwendung von Polymermischungen als Zwischenschicht ist daher stets mit der Bildung von zwei getrennten Phasen zu rechnen. Die an den Phasengrenzen auftretende Lichtstreuung verschlechtert aber die optische Auflösung. Erschwerend kommt hinzu, daß die Ausbildung getrennter Phasen ein zeitabhängiger Prozeß ist, so daß die erreichbare Auflösung von der Lagerzeit des Resists abhängig ist. Ein weiterer Nachteil bei der Verwendung von Polymermischungen besteht in dem erhöhten Produktionsaufwand bei der Herstellung der Resistfilme, der zu einer höheren Ausschußquote und höheren Kosten führt.

Zusammenfassend müssen also an eine Zwischenschicht die folgenden Anforderungen gestellt werden: ausreichende Haftung zu den üblicherweise als Trägerfolie verwendeten Materialien, Haftungsdifferenzierung zwischen photoempfindlicher Schicht und Trägerfolie, gute Löslichkeit in den üblichen basischen Entwicklerlösungen ohne Bildung von Gelen, chemische Einheitlichkeit und problemlose Herstellung.

Überraschenderweise wurde nun gefunden, daß alle genannten Anforderungen erfüllt werden, wenn als Zwischenschicht ein wasserlösliches modifiziertes Vinylalkohol-Polymer verwendet wird, das in einer Menge von 5 bis 75 Gew.% im Polymermolekül chemisch gebundene $[-O-CH_2-CH_2-]x$-Einheiten enthält, wobei x mindestens 4 bedeutet.

Gegenstand dem vorliegenden Erfindung ist ein Photoresistfilm, im wesentlichen bestehend aus

(i) einer Trägerfolie,

(ii) einer darauf aufgebrachten Zwischenschicht und

(iii) einer auf der Zwischenschicht aufgebrachten photoempfindlichen Schicht, sowie gegebenenfalls

(iv) einer Deckfolie auf der photoempfindlichen Schicht, der dadurch gekennzeichnet ist, daß die Zwischenschicht (ii) aus einem in Wasser oder wäßriger Lösung löslichen oder dispergierbaren modifizierten Vinylalkohol-Polymeren besteht, das im Polymermolekül chemisch gebundene $[-O-CH_2-CH_2-]x$-Einheiten in einer Menge von 5 bis 75 Gew.%, vorzugsweise 10 bis 60 Gew.% enthält, wobei x mindestens 4 bedeutet.

Gegenstand der vorliegenden Erfindung ist auch ein Verfahren zur Herstellung einer gedruckten Schaltung, bei dem, in der angegebenen Reihenfolge, ein Photoresistfilm, bestehend aus einer Trägerfolie, einer Zwischenschicht und einer photoempfindlichen Schicht, so auf ein kupferkaschiertes Leiterplattensubstrat auflaminiert wird, daß die photoempfindliche Schicht in Kontakt zur Kupferoberfläche steht, die Trägerfolie von der Zwischenschicht abgezogen wird, die noch durch den Resistfilm verbundenen Leiterplattensubstrate nach bekannten Verfahren vereinzelt werden, die photoempfindliche Schicht durch die Zwischenschicht hindurch bildmäßig belichtet wird und schließlich die Zwischenschicht und die löslichen Stellen der photoempfindlichen Schicht durch Lösen oder Dispergieren entfernt werden. Die löslichen Stellen der photoempfindlichen Schicht sind bei negativ arbeitenden Resisten die unbelichteten Stellen, bei positiv arbeitenden Resisten die belichteten Stellen. Das Entfernen von Trägerfolie und photoempfindlicher Schicht kann dabei in einem Arbeitsgang oder in zwei Arbeitsgängen, gegebenenfalls mit zwei verschiedenen Entwicklerlösungen, erfolgen.

Die photoempfindliche Schicht kann auf der der Trägerfolie abgewandten Seite eine oder mehrere weitere Schichten tragen. Üblicherweise wird die photoempfindliche Schicht mit einer Folie aus Polyethylen oder Polypropylen abgedeckt.

Für die Trägerfolie kann jedes Material verwendet werden, das ausreichende mechanische Eigenschaften ergibt und eine gute Haftungsdifferenzierung der Zwischenschicht zu photoempfindlicher Schicht bzw. Trägerfolie erlaubt. Bevorzugt werden Folien aus Polyolefinen, Polyamiden, Vinylpolymeren, Celluloseestern und Polyestern. Besonders bevorzugt wird Polyethylenterephthalat. Die Schichtdicke der Trägerfolie liegt im allgemeinen zwischen 10 und 100 $\mu$m.

Als photoempfindliche Schicht können sowohl Schichten, die bei Bestrahlung polymerisieren, als auch solche, die bei Bestrahlung löslich werden, verwendet werden. Die Dicke der photoempfindlichen Schicht liegt je nach Verwendungszweck zwischen 15 und 100 $\mu$m, bevorzugt zwischen 25 und 70 $\mu$m.

Im einzelnen ist zur Zusammensetzung der photoempfindlichen Schicht folgendes zu sagen:

Als photoempfindliche Schichten (iii) kommen die in der Photoresisttechnik üblichen positiv bzw. negativ arbeitenden Aufzeichnungsschichten in Frage.

Beispiele für photoempfindliche, negativ arbeitender wäßrig alkalisch entwickelbare Schichten sind Gemische aus

a) einem oder mehreren in Wasser unlöslichen, in wäßrig-alkalischen Lösungen jedoch löslichen oder zumindest dispergierbaren filmbildenden polymeren Bindemitteln,

b) einer oder mehreren photopolymerisierbaren organischen monomeren, mindestens einfach ethylenisch ungesättigten Verbindungungen oder einem Gemisch derartiger monomerer Verbindungen mit einer oder mehreren, mindestens einfach ethylenisch ungesättigten oligomeren Verbindungen,

c) einem Photoinitiatorsystem, sowie gegebenenfalls

d) weiteren üblichen Zusatz- und Hilfsstoffen.

a) Als in Wasser unlösliche, in wäßrig-alkalischen Lösungen jedoch lösliche oder zumindest dispergierbare polymere Bindemittel kommen carboxylgruppenhaltige oder Carbonsäureanhydrid-Gruppen enthaltende Copolymerisate in Betracht, wie z.B. Styrol/Maleinsäureanhydrid-Copolymerisate, Styrol/Maleinsäurehalbester-Copolymerisate, Alkyl(meth)acrylat/(Meth)acrylsäure-Copolymerisate, Copolymerisate aus Styrol, Alkyl(meth)acrylaten und (Meth)acrylsäure sowie gegebenenfalls anderen Monomeren (vgl. u.a. DE-B-20 27 467, DE-A-22 05 146, EP-A-49 504 oder DE-A-27 36 058) oder Copolymerisate, die Acrylsäure und/oder Methacrylsäure, hydrophobe Comonomere und N-Vinylamide einpolymerisiert enthalten, wie sie beispielsweise in DE-A-34 47 356 beschrieben sind. Derartige Copolymerisate können beispielsweise 10 bis 50 Gew.% eines Vinylamids, wie z.B. N-Vinylformamid, N-Vinylacetamid, N-Vinyl-N-Methylacetamid oder N-Vinyllactame, wie N-Vinylpyrrolidon und/oder N-Vinylcaprolactam, 5 bis 30 Gew.% Acrylsäure und/oder Methacrylsäure sowie 30 bis 80 Gew.% mindestens eines hydrophoben Comonomeren, welches als solches in Wasser und wäßrig-alkalischen Lösungen unlösliche Homopolymerisate bildet, einpolymerisiert enthalten.

Als Beispiele für die letztgenannten hydrophoben Comonomeren seien genannt: Vinylaromaten, wie z.B. Styrol, substituierte Styrole, die in der Seitenkette oder im Kern beispielsweise durch Alkylgruppen oder Halogenatome substituiert sind, wie $\alpha$-Methylstyrol, p-Methylstyrol und dergleichen, Vinylacetat sowie die Ester der Acrylsäure und Methacrylsäure, insbesondere die Acrylate und Methacrylate von geradkettigen oder verzweigten Monoalkanolen, vorzugsweise mit 1 bis 4 C-Atomen, wobei hierunter unter anderem das Methylmethacrylat besonders günstig ist. Das Copolymerisat kann ein oder mehrere der hydrophoben Comonomeren einpolymerisiert enthalten, wobei der Anteil der hydrophoben Comonomer-Einheiten in dem Copolymerisat 30 bis 80 Gew.%, vorzugsweise 40 bis 70 Gew.%, bezogen auf das Copolymerisat, betragen kann.

Beispiele für Copolymerisate für den Einsatz als polymeres Bindemittel in den lichtempfindlichen Aufzeichnungsschichten sind u.a. N-Vinyllactam/(Meth)acrylsäure/Methylmethacrylat-Copolymerisate oder N-Vinyllactam/(Meth)acrylsäure/Styrol-Copolymerisate. In einer typischen Ausführungsform können diese Copolymerisate die Comonomeren beispielsweise in Mengen von 25 bis 35 Gew.% an N-Vinylcaprolactam und/oder N-Vinylpyrrolidon, 5 bis 15 Gew.% an (Meth)acrylsäure und 55 bis 65 Gew.% an den hydrophoben Comonomeren, jeweils bezogen auf das Copolymerisat, einpolymerisiert enthalten.

Beispiele für weitere geeignete polymere Bindemittel (a) sind Styrol(Meth)-acrylsäure/Methylmethacrylat/Ethylacrylat-Copolymerisate, die z.B. 10 bis 40 % Styrol, 20 bis 30 % Methacrylsäure, 5 bis 50 % Methylmethacrylat und 0 bis 50 % Ethylacrylat einpolymerisiert enthalten.

Die Comonomeren für die einzusetzenden Copolymerisate (a) werden nach Art und Menge in dem vorstehend angegebenen allgemeinen Rahmen so ausgewählt, daß die Copolymerisate filmbildend sind und die an sie gestellten Forderungen bezüglich ihrer Löslichkeit bzw. Dispergierbarkeit erfüllen. Gegebenenfalls können auch Gemische geeigneter carboxylgruppenhaltiger Copolymerisate eingesetzt werden.

Die als polymeres Bindemittel einzusetzenden Copolymerisate können nach den an sich bekannten und üblichen Polymerisationsmethoden durch Copolymerisation der Comonomeren, beispielsweise in Lösung, hergestellt werden. Für die Lösungspolymerisation eignen sich z.B. niedere Alkanole, Ketone, Ester und ähnliche, wie Methanol, Aceton, Methylethylketon, Ethylacetat etc., als Lösungsmittel. Als Polymerisationsinitiatoren kommen die üblichen radikalischen Starter, wie beispielsweise Azobisisobutyronitril, Benzoylperoxid und dergleichen in Betracht.

Das polymere Bindemittel (a) ist in der photoempfindlichen Schicht im allgemeinen in einer Menge von 1 bis 90 %, vorzugsweise 20 bis 70 Gew.%, bezogen auf das Gesamtgewicht der Aufzeichnungsschicht enthalten.

b) Als photopolymerisierbare organische monomere, mindestens einfach ethylenisch ungesättigten Verbindungen kommen die üblichen ethylenisch ungesättigten photopolymerisierbaren Monomeren in Betracht, vorzugsweise solche mit Siedepunkten über 100 °C und Molekulargewichten < 1000. Diese Monomeren können teilweise durch eine oder mehrere oligomere Verbindungen mit mindestens einer ethylenisch ungesättigten Doppelbindung ersetzt sein, wobei die Molekulargewichte dieser Oligomeren im allgemeinen im Bereich zwischen 1000 und 10.000, vorzugsweise zwischen 1500 und 6000 liegen können.

Die photopolymerisierbaren Monomeren und Oligomeren können dabei sowohl mono- als auch polyfunktionell sein, d.h. eine oder mehrere photopolymerisierbare, ethylenische Doppelbindungen besitzen. Üblicherweise sind in der photopolymerisierbaren Aufzeichnungsschicht bi-oder mehrfunktionelle ethylenisch ungesättigte, photopolymerisierbare Verbindungen allein oder Mischungen hiervon mit einem untergeordneten Anteil an monofunktionellen ethylenisch ungesättigten, photopolymerisierbaren Verbindungen enthalten.

Als Vertreter für die photopolymerisierbaren Monomeren seien insbesondere die Derivate der (Meth)-acrylsäure und ganz besonders die (Meth)acrylsäureester genannt. Beispiele hierfür sind die Di- und Tri-(meth)acrylate von Ethylenglykol, Diethylenglykol, Triethylenglykol oder Polyethylenglykolen mit einem Molekulargewicht bis etwa 500, 1,2-Propandiol, 1,3-Propandiol, Polypropylenglykolen mit einem Molekulargewicht bis etwa 500, 1,4-Butandiol, 1,1,1-Trimethylolpropan, 2,2-Dimethylpropandiol, Glycerin oder Pentaerythrit; Pentaerythrittetra(meth)acrylat, Glucosetri- oder tetra-(meth)acrylat, ferner die Monoacrylate und Monomethacrylate der genannten Diole und Polyole, wie z.B. Ethylenglykol-, Di-, Tri- oder Tetraethylenglykolmono(meth)acrylat, Propandiol-mono(meth)acrylat und Butandiol-mono(meth)acrylat und die (Meth)acrylate von Monoalkanolen, insbesondere von solchen mit 1 bis 20° C-Atomen. Neben den bevorzugten Acrylaten und Methacrylaten der vorstehend genannten Art seien als photopolymerisierbare Monomere auch die Allyl-Verbindungen und andere Vinyl-Verbindungen genannt, wie z.B. N-Vinylpyrrolidon, N-Vinylcaprolactam, Vinylacetat, Vinylpropionat, (Meth)acrylamid, N-Methylol-(meth)acrylamid, der Bisether des Ethylenglykols und N-Methylol-(meth)acrylamids, Vinylcarbamate, Bisacrylamidoessigsäure, Glyoxalbisamid und andere.

Geeignete ethylenisch ungesättigte, photopolymerisierbare Verbindungen für die erfindungsgemäßen lichtempfindlichen Aufzeichnungsschichten sind auch die monomeren Urethanacrylate bzw. -methacrylate mit zwei oder mehr Acrylat- und/oder Methacrylat-Gruppen. Solche monomeren Urethan(meth)acrylate können beispielsweise erhalten werden durch Umsetzung von aliphatischen Di- oder Polyolen mit organischen Diisocyanaten in einem Äquivalentverhältnis OH:NCO von etwa 1:2 und anschließende Umsetzung der freien Isocyanatgruppen des erhaltenen Reaktionsproduktes mit geeigneten Acryloyl- und/oder Methacryloyl-Verbindungen, beispielsweise Hydroxyalkyl-(meth)acrylaten. Als aliphatische Di- oder Polyole kommen unter anderem die vorstehend im Zusammenhang mit den Di- und Tri(meth)acrylaten genannten Di- und Polyhydroxy-Verbindungen in Betracht; als Beispiele für organische Diisocyanate seien Hexamethylendiisocyanat, Toluylendiisocyanat, Isophorondiisocyanat und ähnliche genannt; Hydroxyalkyl(meth)acrylate sind beispielsweise Hydroxyethyl-(meth)acrylat, Propandiol-mono(meth)acrylat oder Butandiol-mono(meth)-acrylat. Ebenso geeignet und vorteilhaft sind Monomere mit zwei oder mehr Acryloyl- und/oder Methacryloyl-Gruppen, wie sie beispielsweise erhalten werden können durch Umsetzung von Di- oder Polyglycidylverbindungen mit Acrylsäure und/oder Methacrylsäure. Als Di- und Polyglycidylverbindungen kommen hier insbesondere die Di- und Polyglycidylether mehrwertiger Phenole, beispielsweise des Bisphenols A oder der Substitutionsprodukte von Bisphenol A, in Betracht. Beispielhaft für solche Acryloyl- und/oder Methacryloyl-Gruppen enthaltenden Monomeren seien die Umsetzungsprodukte des Bisphenol A-bisglycidylethers mit Acryl- und/oder Methacrylsäure im molaren Verhältnis von etwa 1:2 hervorgehoben.

Die ethylenisch ungesättigten, photopolymerisierbaren Monomeren und deren Gemische mit Oligomeren werden dabei - für den Fachmann selbstverständlich - so gewählt, daß sie mit den als polymerem Bindemittel (a) eingesetzten Copolymerisaten verträglich sind. Das Mengenverhältnis von polymerem Bindemittel (a) zu den ethylenisch ungesättigten, photopolymerisierbaren Verbindungen (b) in der lichtempfindlichen Aufzeichnungsschicht kann in weiten Grenzen variiert werden und beispielsweise im Bereich von 30:70 bis 80:20 liegen.

c) Als Photoinitiatoren bzw. Photoinitiatorsystem (c) eignen sich ebenfalls die für lichtempfindliche Aufzeichnungsmaterialien üblichen, die bei Bestrahlung mit aktinischem Licht Radikale bilden und eine Polymerisation der photopolymerisierbaren, olefinisch ungesättigten organischen Verbindungen bewirken und mit den anderen Komponenten verträglich sind, beispielsweise die als Photoinitiatoren bekannten aromatischen Carbonylverbindungen, insbesondere aromatische Ketone, die eine Struktureinheit der Formel

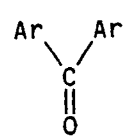

aufweisen, worin Ar für einen gegebenenfalls substituierten Arylrest, insbesondere einen gegebenenfalls substituierten Phenylrest, steht. Die beiden Reste Ar in der Struktureinheit dieser Formel können dabei gleich oder verschieden sein sowie gegebenenfalls auch, beispielsweise über eine -CH-Gruppe oder ein -S-Atom, miteinander verknüpft sein. Als Beispiele für geeignete Photoinitiatoren seien genannt: Benzophenon, substituierte Benzophenone, wie 4,4′-Dichlorbenzophenon, mehrkernige unsubstituierte Chinone, wie Anthrachinon, Benzanthrachinon, 2-Ethylanthrachinon oder tert.-Butylanthrachinon, Thioxanthon und seine Derivate, wie z.B. 2-Methylthioxanthon und 2-Chlorthioxanthon, 2-Isopropylthioxanthon, 2,4-Diethylthioxanthon, Benzoin oder Benzoinderivate, wie dessen Methyl-, Isopropyl-, n-Butyl- oder Isobutylether; symmetrisch oder unsymmetrisch substituierte Benzilacetale, wie Benzildimethylacetal, Benzil-1-methyl-1-ethylacetal; oder Acylarylphosphinoxide wie 2-Dimethoxibenzoyl-diphenylphosphinoxid, 2,4,6-Trimethylbenzoyl-diphenylphosphinoxid, 2,4,6-Trimethylbenzoyl-phenylphosphinsäureethylester oder 2,4,6-Trimethylbenzoyl-phenylphosphinsäure-Natrium-Salz oder substituierte und unsubstituierte Chinone oder 4,4′-Bis-(dimethylamino)benzophenon. Sie können allein oder im Gemisch miteinander oder in Verbindung mit Coinitiatoren verwendet werden, z.B. Ethylanthrachinon mit 4,4′-Bis(dimethylamino)benzophenon, Benzoinmethylether mit Triphenylphosphin, Diacylphosphinoxide mit tertiären Aminen oder Acylarylphosphinoxide mit Benzildimethylacetal.

Als Photoinitiatorsysteme (c) eignen sich vorzugsweise auch Gemische aus

c1) einer Verbindung mit Thioxanthon-Struktur und

c2) einer Hexaarylbisimidazol-Verbindung und

c3) einer mindestens eine Aminogruppe enthaltenden organischen Verbindung, die bei Wellenlängen zwischen 340 nm und 800 nm einen in Lösung gemessenen Extinktionskoeffizienten von weniger als 5000 l/mol•cm aufweist und außer den in α-Stellung zu dem oder den Stickstoffatomen befindlichen Wasserstoffatomen keinen leicht abstrahierbaren Wasserstoff enthält, insbesondere solche, die kein tertiäres Kohlenstoffatom enthält, das durch mehr als eine aromatische Gruppe substituiert ist, wie z.B. Mono-, Di- und Trialkanolamine, Ester der p-Dialkylaminobenzoesäure und p-Dialkylaminobenzaldehyde.

d) Die photolichtempfindlichen Schichten (iii) können noch weitere übliche Hilfs- und Zusatzstoffe (d) enthalten, wie z.B. Weichmacher, Inhibitoren der thermisch initiierten Polymerisation, Farbstoffe, Pigmente, photochrome Zusätze, sensitometrische Regler, Mittel zur Verbesserung der Reliefstruktur, Vernetzungshilfsmittel, Antioxidantien, Füllstoffe, Flußmittel und/oder Formtrennmittel.

Beispiele geeigneter verträglicher Weichmacher sind modifizierte und unmodifizierte Naturöle und -harze, wie paraffinische oder naphthenische Öle, sowie Erdölharze oder Pentaerythritolester von hydriertem Kollophonium; Alkyl-, Alkenyl-, Aralkyl- oder Arylalkenylalkoholester von Säuren, wie Zitronensäure, Essigsäure, Propionsäure, Buttersäure, Ethylbuttersäure, Ethylhexansäure, Glykolsäure, Benzoesäure, Phthalsäure, Trimellitsäure, Abietinsäure, Phosphorsäure oder Stearinsäure; synthetische Oligomere oder Harze wie Oligostyrol, oligomere Styrol-Butadien-Copolymerisate, Oligo-α-methylstyrol, oligomere α-Methylstyrol-Vinyltoluol-Copolymerisate, flüssige 1,2- oder 1,4-Oligobutadiene und Oligopentadiene.

Geeignete thermische Polymerisationsinhibitoren sind z.B. Hydrochinon, Hydrochinon-Derivate, 2,6-Di-t.-butyl-p-cresol, Nitrophenole, N-Nitrosoamine, wie N-Nitrosodiphenylamin oder die Salze des N-Nitrosocyclohexylhydroxylamins. Beispiele für Farbstoffe und/oder Pigmente, die sowohl als Kontrastmittel als auch schichtverfestigend wirken können, sind u.a. Brilliant Green Dye (C.I. 42 040), Viktoria-Reinblau FGA, Viktoria-Reinblau BO (C.I. 42 595), Viktoria-Blau B (C.I. 44 045), Rhodamin 6 G (C.I. 45 160), Triphenylmethanfarbstoffe, wie z.B. Sicomet® Patentblau 80E131, Naphthalimidfarbstoffe und 3′-Phenyl-7-dimethylamino-2,2′-spiro-di-(2H-1-benzopyran). Zu den sensitometrischen Reglern gehören Verbindungen wie z.B. 9-Nitroanthracen, 10,10′-Bisanthron, Phenazinium-, Phenoxazinium-, Acridinium- oder Phenothiazinium-Farbstoffe, insbesondere in Kombination mit milden Reduktionsmitteln, 1,3-Dinitrobenzole und ähnliche. Die Zusatz- und/oder Hilfsstoffe sind in den photopolymerisierbaren Aufzeichnungsschichten in den für diese Stoffe üblichen und bekannten wirksamen Mengen vorhanden. Ihre Gesamtmenge sollte jedoch im allgemeinen 20 Gew.%, vorzugsweise 10 Gew.%, bezogen auf die lichtempfindliche Aufzeichnungsschicht, nicht überschreiten.

Das Mischungsverhältnis, in dem die einzelnen Komponenten in der photoempfindlichen Schicht (iii) enthalten sind, wird im allgemeinen so gewählt, daß diese Schicht (iii) nicht nur wäßrig-alkalisch entwickelbar, sondern vorteilhafterweise auch bei Raumtemperatur fest und wenig klebrig ist und gute Filmbildungseigenschaften besitzt. Die Zusammensetzung wird darüber hinaus so gewählt, daß die photoempfindliche Schicht gut laminierbar und unter Anwendung von Druck sowie gegebenenfalls Wärme auf ein Substrat übertragbar ist. Für die Herstellung von Resistmustern werden üblicherweise Schichtdicken der lichtempfindlichen Aufzeichnungsschicht im Bereich von etwa 1 bis 100 µm eingestellt.

Für positiv arbeitende Photoresistschichten geeignete Zusammensetzungen und deren Aufbaukomponenten können beispielsweise den DE-A-20 28 903, DE-A-22 36 941und DE-A-21 50 691 sowie der EP-A-00 19 770 entnommen werden.

Die photoempfindliche Schicht (iii) kann z.B. durch Sprühen oder Gießen aus einem geeigneten Lösemittel auf die mit der Zwischenschicht beschichtete Trägerfolie aufgebracht werden. Eine weitere Möglichkeit besteht darin, die photoempfindliche Schicht zunächst auf einem Hilfsträger, z.B. einer Folie aus Polyethylenterephthalat, herzustellen und dann durch Laminieren oder Kaschieren auf die lösliche

Zwischenschicht zu übertragen.

Die Zwischenschicht (ii) dient nach dem Laminieren und Abziehen der Trägerfolie als Schutzfilm für die photoempfindliche Schicht. Ihre Oberfläche muß daher glatt und, um Verschmutzungen des Negativs zu vermeiden, klebfrei sein. Bei Verwendung von photopolymerisierbaren Zusammensetzungen als photoempfindliche Schicht dient die Zwischenschicht (ii) auch als Sauerstoffsperre. Für den Fachmann selbstverständlich muß die Zwischenschicht gegen aktinisches Licht transparent sein. Die Zwischenschicht wird nach einer der bekannten Methoden zur Herstellung dünner Filme auf die Trägerfolie aufgebracht, beispielsweise durch Gießen aus Lösung und anschließendes Trocknen.

Um eine hohe Auflösung zu erzielen, wird man die Zwischenschicht (ii) so dünn wie möglich wählen, also etwa 1 bis 10 µm. Es sind aber auch Anwendungen denkbar, bei denen nicht die hohe Auflösung, sondern die vereinfachte Entfernung der Trägerfolie im Mittelpunkt stehen. In diesen Fällen kann auch eine dickere Zwischenschicht verwendet werden, doch wird man im allgemeinen die Dicke der Zwischenschicht auf etwa 50 µm begrenzen, um eine Verlängerung der Entwicklungszeit zu vermeiden.

Die als Zwischenschicht erfindungsgemäß verwendeten wasserlöslichen modifizierten Vinylalkohol-Polymere, die in einer Menge von 5 bis 75, bevorzugt 10 bis 60 und insbsondere 15 bis 40 Gew.% $[O-CH_2-CH_2]x$-Einheiten, d.h. mehrere zusammenhängende umgesetzte Ethylenoxid-Einheiten im Polymermolekül chemisch gebunden enthalten, sind an sich bekannt und ihre Herstellung ist z.B. in den deutschen Patentschriften 575 141, 1 081 229, 1 094 457, der französischen Patentschrift 1 239 634 und der US-Patentschrift 3 052 652 beschrieben. Geeignet sind solche modifizierten Vinylalkohol-Polymeren, die zumindest den größeren Teil der Ethylenoxid-Einheiten in Form von $(O-CH_2-CH_2)x$-Blöcken gebunden enthalten, wobei x mindestens 4 bedeutet.

Recht geeignete wasserlösliche modifizierte Vinylalkohol-Polymere sind wasserlösliche Umsetzungsprodukte eines Vinylalkohol-Polymeren bzw. Polyvinylalkohols mit Ethylenoxid, wobei der Anteil der umgesetzten Ethylenoxid-Einheiten im Umsetzungsprodukt den vorgenannten Prozentsatz ausmacht, der sich auf das fertige Umsetzungsprodukt bezieht. Die Herstellung der Umsetzungsprodukte ist an sich bekannt und z.B. in der deutschen Patentschrift 575 141, der französischen Patentschrift 1 239 634 und der US-Patentschrift 3 052 652 angegeben. Sie können durch Umsetzung der Vinylalkohol-Polymeren mit Ethylenoxid unter den für Oxethylierung üblichen Bedindungen in Gegenwart von sauren oder basischen Katalysatoren hergestellt werden. Geeignete Katalysatoren für die Umsetzung von Polyvinylalkohol mit Ethylenoxid sind z.B. Antimonpentafluorid, Aluminiumchlorid, Schwefelsäure, Bortrifluorid-Etherat, Alkalihydroxid, Alkalialkoholat, Amine, Benzyltrimethylammoniumhydroxid, von denen Schwefelsäure, Bortrifluorid-Etherat und Benzyltrimethylammoniumhydroxid bevorzugt sind. Im allgemeinen erfolgt die Oxalkylierung bei 30 bis 150 °C während etwa 2 bis 12 Stunden. Als Vinylalkohol-Polymere bzw. Polyvinylalkohole, worunter Polymere und Copolymere verstanden werden, die wiederkehrende $-CH_2-CH(OH)$-Einheiten im Polymermolekül enthalten, sind für die Umsetzung solche geeignet, die bei der Umsetzung mit Ethylenoxid wasserlösliche Umsetzungsprodukte geben. Besonders geeignet sind zu etwa 70 bis 100 Mol% verseifte Polyvinylester, insbesondere verseifte Polyvinylacetate mit einem Molekulargewicht von etwa 5.000 bis 200.000 und insbesondere 15.000 bis 50.000.

Sehr geeignete wasserlösliche modifizierte Vinylalkohol-Polymere sind solche, die durch Verseifung eines Pfropfpolymerisats von Vinylestern von Monocarbonsäuren auf Polyethylenglykol hergestellt sind. Die Herstellung solcher modifizierter Vinylalkohol-Polymerer ist besonders in den deutschen Patentschriften 1 081 229 und 1 094 457 beschrieben, die Herstellung der Ausgangsprodukte, der Vinylester-Pfropfpolymerisate insbesondere in der deutschen Patentschrift 1 077 430. Als Vinylester von Monocarbonsäuren eignen sich für die Herstellung der Pfropfpolymerisate neben z.B. Vinylbenzoat besonders handelsübliche Vinylester von aliphatischen Monocarbonsäuren mit 2 bis 18 C-Atomen, wie Vinylpropionat, Vinylbutyrat und insbesondere Vinylacetat. Als Polyethylenglykole bzw. Polyethylenoxide für die Pfropfpolymerisation, die zweckmäßigerweise in Gegenwart von radikalischen Aktivatoren in homogener Phase erfolgt, eignen sich solche mit mehr als vier Oxyethylen-Einheiten im Molekül, bevorzugt solche mit Molekulargewichten von 2.000 bis 25.000. Gut geeignet sind modifizierte Polyvinylalkohole dieser Art, bei denen 30 bis 98 Mol% und insbesondere 60 bis 95 Mol% der Estergruppen des Vinylester-Pfropfpolymerisats verseift sind. Stets sollen die resultierenden modifizierten Vinylalkohole jedoch wasserlöslich sein.

Zur Herstellung gedruckter Schaltungen unter Verwendung des erfindungsgemäßen Photoresistfilms wird zweckmäßigerweise zunächst die Polyethylen- bzw. Polypropylendeckfolie von der photoempfindlichen Schicht entfernt. Das Entfernen der Deckfolie erfolgt im allgemeinen im Laminator, indem die Deckfolie vor den Laminierwalzen abgezogen und auf eine Rolle gewickelt wird. Die photoempfindliche Schicht wird dann in Kontakt zu der Oberfläche eines kupferkaschierten Leiterplattensubstrats gebracht und durch zwei auf 80 bis 140 °C beheizte Walzen auf das Leiterplattensubstrat auflaminiert. Unmittelbar nach dem Passieren der Laminierwalzen wird die Trägerfolie abgezogen und auf einer Rolle aufgewickelt. Danach werden die Platten

vereinzelt und nach den üblichen Verfahren bildmäßig mit aktinischem Licht belichtet, wobei sich hierfür die üblichen Lichtquellen von aktinischem Licht, wie beispielsweise UV-Fluoreszenzröhren, Quecksilberhoch-, -mittel- oder -niederdruckstrahler, superaktinische Leuchtstoffröhren, Xenon-Impulslampen, aber auch UV-Laser, Argonlaser und ähnliche, eignen. Die von den Lichtquellen emittierte Wellenlänge soll im allgemeinen zwischen 230 und 600 nm, bevorzugt zwischen 300 und 420 nm, liegen und insbesondere auf die Eigenabsorption des in der photopolymerisierbaren Aufzeichnungsschicht enthaltenen Photoinitiators abgestimmt sein. Nach dem Belichten sind, je nach verwendetem Resisttyp, die unbelichteten Teile (Negativresist) oder die belichteten Teile (Positivresist) der photoempfindlichen Schicht in einem Entwicklermedium löslich, während die übrigen Teile unlöslich sind. Im nächsten Schritt kann die Zwischenschicht mit Wasser entfernt werden, danach werden in einem zweiten Schritt die löslichen Teile der photoempfindlichen Schicht durch einen geeigneten Entwickler entfernt. Dieses zweistufige Entwicklungsverfahren wird man besonders dann verwenden, wenn es sich bei dem Entwicklermedium für die photoempfindliche Schicht um ein organisches Lösungsmittel handelt. Besonders vorteilhaft ist es jedoch, als photoempfindliche Schicht (iii) eine in wäßriger Lösung, z.B. wäßriger Sodalösung, entwickelbare Zusammensetzung zu verwenden. In diesem Fall können die Zwischenschicht und die löslichen Teile der photoempfindlichen Schicht in einem Schritt entfernt werden, wobei die für die photoempfindliche Schicht geeignete Entwicklerlösung verwendet wird. Nach dem Entfernen der löslichen Teile der photoempfindlichen Schicht wird die freiliegende Kupferoberfläche durch Ätzen oder Galvanisieren dauerhaft modifiziert.

Der Vorteil der erfindungsgemäßen lichtempfindlichen Aufzeichnungsschichten gegenüber herkömmlichen Systemen ohne lösliche Zwischenschicht besteht darin, daß das Abziehen der Trägerfolie vor dem Vereinzeln der Platten erfolgen kann und somit einer leichten Automatisierung zugänglich ist. Zu einer Beeinträchtigung der übrigen Eigenschaften der lichtempfindlichen Aufzeichnungsschicht kommt es dabei nicht. Ein weiterer Vorteil besteht darin, daß bei Verwendung dünner Zwischenschichten eine erhebliche Steigerung der Auflösung gegenüber herkömmlichen Aufzeichnungsschichten erreicht werden kann. Die erfindungsgemäß eingesetzten Zwischenschichten zeichnen sich durch hohe Flexibilität und Elastizität aus. Die Haftung der Zwischenschicht zu den üblichen Trägerfolien ist bei allen bei normaler Verarbeitung auftretenden Temperaturen (15 bis 95 °C) gut, jedoch stets deutlich geringer als die Haftung der Zwischenschicht (ii) zur photoempfindlichen Schicht (iii). Das zur Herstellung der Zwischenschicht verwendete wasserlösliche modifizierte Vinylalkohol-Polymere ist in basischen Lösungen ausgezeichnet löslich, ohne daß es zu der bei gewöhnlichem Polyvinylalkohol beobachteten Gelbildung kommt. Die Herstellung solcher modifizierter Vinylalkohol-Polymerer ist, wie oben bereits erwähnt, bekannt und wird im technischen Maßstab durchgeführt. Da zur Einstellung der geforderten Eigenschaften keine Abmischungen mit anderen Polymeren nötig sind, werden Probleme, die durch Entmischung entstehen könnten, vermieden. Auf Weichmacher kann ebenfalls verzichtet werden, so daß Veränderungen der Resisteigenschaften durch Diffusion des Weichmachers in die photopolymere Schicht unterbleiben. Die Entwicklungszeiten werden durch die Verwendung der erfindungsgemäßen Zwischenschichten nur unwesentlich verlängert.

Die Erfindung wird durch die nachfolgenden Beispiele näher erläutert. Die in den Beispielen genannten Teile und Prozente beziehen sich, sofern nicht anders angegeben, auf das Gewicht.

Beispiel 1

Eine 20 %ige wäßrige Lösung eines verseiften Pfropfpolymerisats von Vinylacetat auf Polyethylenglykol (Molekulargewicht 30.000 bis 35.000; Gehalt an Polyethylenglykol: 24 %; Verseifungsgrad: 82 Mol%) wurde so auf eine 23 µm starke Polyesterfolie gegossen, daß eine Trockenschichtdicke des modifizierten Vinylalkohol-Polymeren von 30 µm resultierte. Nach dem Ablüften der Schicht wurde auf die beschichtete Seite der Polyesterfolie eine Gießlösung aufgebracht, die durch Mischen der folgenden Komponenten hergestellt worden war:

| | |
|---|---|
| (1) 37 %ige Lösung (in Methylethylketon/Isopropanol 1/1) eines Copolymeren aus Styrol (23 %), Methylmethacrylat (35 %), Butylacrylat (11 %) und Methacrylsäure (30 %) mit einem K-Wert nach Fikentscher von 42 | 149,80 g |
| (2) Trimethylolpropantriacrylat | 38,00 g |
| (3) Sicomet Patentblau 80E131 | 0,05 g |
| (4) Ethyl-(p-dimethylamino)benzoat | 3,00 g |
| (5) Isopropylthioxanthon | 0,50 g |

Nach dem Ablüften und Trocknen (90 °C, 5 min) resultierte eine Trockenschichtdicke der photoempfindlichen Schicht von 38 µm. Die photoempfindliche Schicht wurde mit einer 23 µm starken Polyethylenfolie abgedeckt. Danach wurde der Folienverbund aus Polyesterfolie, Zwischenschicht, photoempfindlicher Schicht und Polyethylenfolie auf eine Rolle gewickelt. Zur Prüfung wurde der Resist von der Rolle abgewickelt, die Polyethylenfolie abgezogen und der Resistfilm mit der photoempfindlichen Schicht zum Kupfer auf die kupferkaschierte Oberfläche eines Leiterplattensubstrates laminiert (105 °C, 1,5 m/min). Unmittelbar nach dem Laminieren wurde die Polyesterfolie abgezogen. Danach wurden die Platten vereinzelt. Danach wurde die photoempfindliche Schicht in einem Riston® PC-Printer durch ein Testnegativ belichtet. Nach der Belichtung wurde 30 Sekunden in 1 %iger Sodalösung entwickelt.

Zum Vergleich wurde die gleiche Gießlösung auf eine 23 µm starke Polyesterfolie ohne Zwischenschicht gegossen. Dieser Resist wurde analog verarbeitet, jedoch wurde die Polyesterfolie erst nach dem Belichten abgezogen. Mit beiden Resisten wurden umfangreiche Prüfungen durchgeführt. Dabei ließen sich, außer der leichteren Verarbeitbarkeit des erfindungs gemäßen Resistfilms, keine Unterschiede hinsichtlich der für die Leiterplattenfertigung wichtigen Resisteigenschaften (Ätzbeständigkeit, Verhalten in den Galvanikbädern, Tenting, Strippverhalten, Auflösung) feststellen.

Beispiel 2

Der Resist des Beispiels 1 wurde wie dort beschrieben laminiert und nach Abziehen der Polyesterfolie belichtet. Danach wurde zunächst in einem mit destilliertem Wasser gefüllten Sprühwascher die Zwischenschicht aufgelöst (20 °C, Verweilzeit 10 Sekunden), anschließend wurde 25 Sekunden lang in einem weiteren Sprühwascher mit 1 %iger Sodalösung bei 30 °C entwickelt, wobei sich die unbelichteten Teile des Resists vollständig ablösten. Auch bei dieser Verarbeitung wurden keine Unterschiede zu dem in Beispiel 1 als Vergleich verwendeten Resist festgestellt.

Beispiel 3

Eine Gießlösung zur Herstellung eines Photoresistfilms wurde durch Mischen der folgenden Komponenten hergestellt:

| | |
|---|---|
| (1) Ethylacetat | 76,00 g |
| (2) Copolymer aus Methylmethacrylat (98 %) und Acrylsäure (2 %) mit einem mittleren Molekulargewicht von 153.000 | 25,50 g |
| (3) Trimethylolpropantriacrylat | 8,80 g |
| (4) äquimolares Umsetzungsprodukt aus Bisphenol-A-bisglycidylether und Acrylsäure | 8,00 g |
| (5) 2,2′-Bis-(o-chlorphenyl)-4,4′,5,5′-tetra-(p-methoxyphenyl)bisimidazolyl | 1,20 g |
| (6) Triethylenglykoldiacetat | 1,60 g |
| (7) Sicometpatentblau 80E131 | 0,02 g |
| (8) Tris(dimethylaminophenyl)methan | 0,25 g |

Die filtrierte Lösung wurde so auf die in Beispiel 1 beschriebene beschichtete Polyesterfolie aufgebracht, daß nach dem Ablüften des Lösungsmittels und Trocknen (3 Minuten bei 90° C) eine Trockenschichtdicke der photoempfindlichen Schicht von 35 µm resultierte. Die so hergestellte photopolymerisierbare Resistschicht wurde bis zur Weiterverarbeitung mit einer Polyethylenfolie abgedeckt. Zur Prüfung wurde die Polyethylenfolie abgezogen und der Resist wie üblich laminiert. Danach wurde die Polyesterfolie abgezogen, und die Platten wurden vereinzelt. Nach Belichtung wurde der Resist zunächst zur Entfernung der Zwischenschicht bei 20° C 10 Sekunden in einem Sprühwascher mit destilliertem Wasser behandelt. Anschließend wurden die unbelichteten Teile des Resists im Laufe von Sekunden mit 1,1,1-Trichlorethan entfernt.

Zum Vergleich wurde die gleiche Gießlösung ohne Zwischenschicht auf eine Polyesterfolie aufgebracht. Zur Prüfung des Vergleichsbeispiels wurde die Polyesterfolie erst nach dem Belichten abgezogen und der Resist danach ebenfalls in 1,1,1-Trichlorethan entwickelt. Auch hier wurden keine Unterschiede in der Qualität des Resists festgestellt.

Beispiel 4

Eine 7,5 %ige wäßrige Lösung des in Beispiel 1 beschriebenen modifizierten Vinylalkohol-Polymeren wurde so auf eine 23 µm starke Polyesterfolie gegossen, daß eine Trockenschichtdicke des Vinylalkohol-Polymeren von 5 µm resultierte. Nach dem Ablüften der Schicht wurde auf die beschichtete Seite der Polyesterfolie die Gießlösung des Beispiels 1 aufgebracht und wie dort beschrieben getrocknet. Es ergab sich eine Dicke der photoempfindlichen Schicht von 38 µm. Zur Prüfung wurde der Resist so auf ein kupferkaschiertes Leiterplattensubstrat auflaminiert, daß die photoempfindliche Schicht in Kontakt zur Kupferoberfläche stand. Nach dem Laminieren wurde die Polyesterfolie abgezogen und der Resist durch ein Testnegativ belichtet. Anschließend wurde 30 Sekunden in 0,75 %iger Natriumcarbonatlösung entwikkelt. Die Prüfung des Resists wurde durch galvanische Abscheidung von Kupfer und dann Zinn, Entfernen des belichteten Resists mit 3 %iger Kaliumhydroxidlösung und Entfernung des Basiskupfers in ammoniakalischer Kupferchloridlösung vervollständigt. Die dabei erzielte Auflösung betrug 40 µm, während mit dem in Beispiel 1 angeführten Vergleich nur eine Auflösung von 100 µm erzielt werden konnte.

## Ansprüche

1. Photoresistfilm, im wesentlichen bestehend aus
(i) einer Trägerfolie,
(ii) einer darauf aufgebrachten Zwischenschicht und
(iii) einer auf der Zwischenschicht aufgebrachten photoempfindlichen Schicht,
sowie gegebenenfalls
(iv) einer Deckfolie auf der photoempfindlichen Schicht, dadurch gekennzeichnet, daß die Zwischenschicht (ii) aus einem in Wasser oder in wäßriger Lösung löslichen oder dispergierbaren modifizierten Vinylalkohol-Polymeren besteht, das im Polymermolekül chemisch gebundene [$-O-CH_2-CH_2-$]x-Einheiten in einer Menge von 5 bis 75 Gew.% enthält, wobei x mindestens 4 bedeutet.

2. Photoresistfilm nach Anspruch 1, dadurch gekennzeichnet, daß das für die Zwischenschicht verwendete modifizierte Vinylalkohol-Polymere einen Anteil von 10 bis 60 Gew.% von im Polymermolekül

gebundenen [-O-$CH_2$-$CH_2$-]x-Einheiten enthält, wobei x mindestens 4 beträgt.

3. Photoresistfilm nach Anspruch 1 oder 2, dadurch gekennzeichnet, daß das für die Zwischenschicht verwendete modifizierte Vinylalkohol-Polymere durch Verseifung eines Pfropfpolymerisats von Vinylestern von Monocarbonsäuren auf Polyethylenglykol erhalten worden ist.

4. Photoresistfilm nach Anspruch 1 oder 2, dadurch gekennzeichnet, daß das für die Zwischenschicht verwendete modifizierte Vinylalkohol-Polymere das Umsetzungsprodukt eines Vinylalkohol-Polymeren mit Ethylenoxid ist.

5. Photoresistfilm nach Anspruch 3, dadurch gekennzeichnet, daß 30 bis 98 Mol% der Estergruppen des Vinylester-Pfropfpolymerisats verseift sind.

6. Photoresistfilm nach einem der Ansprüche 1 bis 5, dadurch gekennzeichnet, daß die Trägerfolie so gewählt wird, daß die Haftung der Zwischenschicht zur Trägerfolie geringer ist als die Haftung der Zwischenschicht zur photoempfindlichen Schicht.

7. Photoresistfilm nach einem der Ansprüche 1 bis 5, dadurch gekennzeichnet, daß es sich bei der Trägerfolie um eine Polyethylenterephthalatfolie handelt.

8. Verfahren zur Herstellung einer gedruckten Schaltung, dadurch gekennzeichnet, daß in der angegebenen Reihenfolge (1) eine lichtempfindliche Aufzeichnungsschicht nach einem der vorhergehenden Ansprüche, gegebenenfalls nach Abziehen der Deckfolie, so auf ein kupferkaschiertes Leiterplattensubstrat auflaminiert wird, daß die photoempfindliche Schicht in Kontakt zur Kupferoberfläche steht, (2) die Trägerfolie von der Zwischenschicht abgezogen wird, (3) die noch durch den Resistfilm verbundenen Leiterplattensubstrate nach bekannten Verfahren vereinzelt werden, (4) die lichtempfindliche Aufzeichnungsschicht durch die Zwischenschicht hindurch bildmäßig belichtet wird, (5) die Zwischenschicht in Wasser entfernt wird, (6) die löslichen Stellen der photoempfindlichen Schicht in einem Entwicklermedium entfernt werden und (7) die freigelegte Kupferoberfläche den üblichen weiteren Bearbeitungsschritten wie Ätzen oder galvanischer Metallabscheidung unterworfen wird.

9. Verfahren nach Anspruch 8, dadurch gekennzeichnet, daß die Zwischenschicht und die nach der Belichtung noch löslichen Stellen der photoempfindlichen Schicht in einem Schritt mit wäßriger Natriumcarbonatlösung entfernt werden.